# EUROPÄISCHE PATENTSCHRIFT

(11) **EP 2 478 531 B1**
(45) Veröffentlichungstag und Bekanntmachung des Hinweises auf die Patenterteilung: **20.06.2018**
(21) Anmeldenummer: 10735016.7
(22) Anmeldetag: 27.07.2010
(51) Int. Cl.: G08C 17/04, H01L 43/06

(54) **INTEGRIERTER SCHALTKREIS ZUR INFORMATIONSÜBERTRAGUNG**
INTEGRATED CIRCUIT FOR TRANSFERRING INFORMATION
CIRCUIT INTÉGRÉ POUR TRANSMETTRE DES INFORMATIONS

(30) Priorität: 17.09.2009 DE 102009029528
(43) Veröffentlichungstag der Anmeldung: 25.07.2012
(73) Patentinhaber: Robert Bosch GmbH, 70442 Stuttgart (DE)
(72) Erfinder: RETTIG, Rasmus, 72760 Reutlingen (DE); SCHIEMANN, Werner, 70734 Fellbach (DE); KALB, Franziska, 95686 Fichtelberg (DE)
(86) Internationale Anmeldenummer: PCT/EP2010/060893
(87) Internationale Veröffentlichungsnummer: WO 2011/032764

(56) Entgegenhaltungen:
- JP-A- 8 264 857
- JP-A- 57 048 264
- US-A1- 2009 001 964
- US-B2- 7 042 323

## Beschreibung

Die Erfindung betrifft einen integrierten Schaltkreis zur Informationsübertragung.

### Stand der Technik

Im Rahmen der Nutzung hoher elektrischer Spannungen, zum Beispiel im Bereich der Elektronik für die Kraftfahrzeugtechnik besteht das Erfordernis, einzelne elektronische Schaltungen galvanisch voneinander zu trennen, das heißt unterschiedliche Schaltungen auf unterschiedlichen Gleichspannungspotentialen zu halten. Gleichzeitig müssen Daten zwischen diesen Schaltungen mit hoher Geschwindigkeit ausgetauscht werden. Datenraten liegen typischer Weise zwischen wenigen 100 Kilobit/Sekunde bis zu 50 - 100 Megabit/Sekunde bei Potentialdifferenzen zwischen wenigen 100 Volt und mehreren Kilovolt.

Aus der DE 42 05 241 C2 ist eine potentialfreie Datenübertragungseinrichtung zwischen einer Master- und mindestens einer monolithisch integrierten Unterstufe bekannt, welche eine Hall-Spannungsmesseinrichtung aufweist, die über das Magnetfeld einer mit der Unterstufe räumlich eng verbundenen, insbesondere mitintegrierten, Koppelschleife den jeweiligen Strom einer an die Koppelschleife angeschlossenen, niederohmig und induktivitätsarm ausgeführten, zweiadrigen Busleitung als Dateninformation auswertet. Die JP63142876 offenbart den Oberbegriff des Anspruchs 1.

### Offenbarung der Erfindung

Die vorliegende Erfindung schafft einen integrierten Schaltkreis zur Informationsübertragung mit einem Substrat, mindestens einem in dem Substrat integrierten oder auf dem Substrat angeordneten Hall-Element, einer im Wesentlich konzentrisch zu dem Hall-Element und in vertikaler Richtung zu dem Hall-Element beabstandet angeordneten sowie von diesem galvanisch getrennten ersten Spule und mindestens einer im Wesentlichen konzentrisch zu dem Hall-Element und von diesem galvanisch getrennten sowie in vertikaler Richtung zu dem Hall-Element und der ersten Spule beabstandet angeordneten zweiten Spule, wobei die erste Spule und die zweite Spule elektrisch derart in Reihe geschaltet sind, dass sich in den Spulen ein Stromfluss in gleicher Richtung und dadurch eine konstruktive Überlagerung ihrer Magnetfelder ergibt.

Die erfindungsgemäße Informationsübertragung basiert auf folgendem Grundprinzip: Ein Magnetfeld, welches durch einen durch eine Spule fließenden Datenstrom, welcher die Dateninformation darstellt, erzeugt wird, wird mit Hilfe eines elektrisch von der felderzeugenden Spule isolierten Hall-Elements gemessen. Das Ausgangssignal des Hall-Elements liefert dabei die zu übertragende Information auf der galvanisch entkoppelten Seite der Schaltung. Das Vorsehen mindestens zweier übereinander angeordneter Spulen, welche derart in Reihe geschaltet sind, dass sich in den Spulen ein Stromfluss in gleicher Richtung ergibt, führt zu einer Erhöhung, bei zwei annähernd gleichen Spulen in etwa einer Verdopplung, des Magnetfeldes und damit zu einer entsprechenden Erhöhung des Signalhubs des Ausgangssignals des Hall-Elements. Die Qualität und Zuverlässigkeit der Informationsübertragung sowie die maximal erzielbare Datenrate wird auf diese Weise deutlich gesteigert. Ein weiterer, mit der erfindungsgemäßen Ausgestaltung des integrierten Schaltkreises verbundener Vorteil besteht darin, dass der gesamte Aufbau mit Bauteilen der Halbleitertechnologie, insbesondere Siliziumtechnologie, integrierbar und kombinierbar ist, was eine platzsparende und kostengünstige Herstellung ermöglicht. Gemäß einer Ausführungsform der Erfindung ist dazu eine erste Isolationsschicht vorgesehen, welche zwischen dem Hall-Element und der ersten Spule angeordnet ist und eine zweite Isolationsschicht, welche zwischen der ersten Spule und der zweiten Spule angeordnet ist. Außerdem kann der Schaltkreis auch direkt mit weiterer Elektronik auf einem gemeinsamen Chip integriert werden.

Gemäß einer Ausführungsform der Erfindung kann mindestens eine Kompensationsspule vorgesehen sein, welche elektrisch getrennt angesteuert wird, das heißt nicht den Datenstrom führt. Diese zusätzliche Kompensationsspule ist im Wesentlichen konzentrisch zu dem Hall-Element und in vertikaler Richtung zu dem Hall-Element und den datentragenden Spulen beabstandet angeordnet.

Durch Verwendung einer Kompensationsspule kann das Hall-Element weitestgehend im Bereich des Nulldurchganges, da heißt im Gleichgewicht, betrieben werden, so dass Verzögerungen durch eine im Hall-Element ablaufende Ladungstrennung minimiert werden. Auf diese Weise kann die erreichbare Datenrate der Informationsübertragung merklich erhöht werden.

Gemäß einer weiteren Ausführungsform der Erfindung weist der integrierte Schaltkreis mindestens ein zweites in dem Substrat integriertes oder auf dem Substrat angeordnetes Hall-Element, eine im Wesentlichen konzentrisch zu dem zweiten Hall-Element und in vertikaler Richtung zu dem zweiten Hall-Element beabstandet angeordnete und von diesem galvanisch getrennte dritte Spule und mindestens eine im Wesentlichen konzentrisch zu dem zweiten Hall-Element und in vertikaler Richtung zu dem zweiten Hall-Element und der dritten Spule beabstandet angeordnete vierte Spule auf, wobei die Spulen elektrisch derart in Reihe geschaltet sind, dass sich in der dritten und vierten Spule ein Stromfluss in gleicher Richtung ergibt, welcher entgegengesetzt zu dem Stromfluss in der ersten und zweiten Spule ist.

Das Vorsehen zweier nebeneinander liegender Spulenpaare, die derart verschaltet sind, dass sich in den beiden übereinander angeordneten Spulen jeweils ein Stromfluss in gleicher Richtung ergibt und in den beiden nebeneinander angeordneten Spulen jeweils ein Stromfluss in entgegen gesetzter Richtung ergibt, ermöglicht eine differentielle Auswertung der Ausgangssignale der Hall-Elemente und führt auf diese Weise zu einer deutlichen Verbesserung der Störfestigkeit gegenüber homogenen externen Magnetfeldern.

Gemäß einer weiteren Ausführungsform der Erfindung ist mindestens eine der Spulen, insbesondere die dem Hall-Element nächstgelegene Spule, kreisringförmig ausgestaltet, insbesondere derart, dass sich vertikal kein Überlappungsbereich der Spule mit dem darunter liegenden Hall-Element ergibt. Durch die kreisringförmige Ausgestaltung der Spule und die damit verbundene Verringerung oder sogar Beseitigung einer Überlappung der Spule mit dem zugeordneten Hall-Element wird ein größerer Abstand und damit eine reduzierte elektrische Feldstärke zwischen der Spule und dem Hall-Element realisiert. Auf diese Weise wird die Durchbruchfestigkeit erhöht, was insbesondere bei großen Potentialdifferenzen zwischen Spule und Hall-Element vorteilhaft ist.

Denkbar ist auch ein integrierter Schaltkreis zur Informationsübertragung mit einem Substrat, mindestens einem ersten Hall-Element und einem zweiten Hall-Element, welche in dem Substrat integriert oder auf dem Substrat angeordnet sind, einer im Wesentlichen konzentrisch zu dem ersten Hall-Element und in vertikaler Richtung zu dem ersten Hall-Element beabstandet angeordneten sowie von diesem galvanisch getrennten ersten Spule und einer im Wesentlichen konzentrisch zu dem zweiten Hall-Element und von diesem galvanisch getrennten sowie in vertikaler Richtung zu dem zweiten Hall-Element beabstandet angeordneten zweiten Spule, wobei die erste Spule und die zweite Spule elektrisch derart in Reihe geschaltet sind, dass sich in den Spulen ein Stromfluss in entgegen gesetzter Richtung ergibt. Durch die auf diese Weise ermöglichte differentielle Auswertung der Ausgangssignale der beiden Hall-Elemente ergibt sich eine erhöhte Störfestigkeit gegenüber homogenen externen Magnetfeldern.

Dabei kann eine Isolationsschicht vorgesehen sein, welche zwischen den Hall-Elementen und den Spulen angeordnet ist, so dass diese vollständig zum übrigen integrierten Schaltkreis isoliert wird.

Durch eine kreisringförmige Ausgestaltung der Spulen, insbesondere derart, dass sich kein Überlappungsbereich mit dem jeweils zugeordneten Hall-Element ergibt, kann auch bei einem derart ausgestalteten integrierten Schaltkreis eine Erhöhung der Durchbruchfestigkeit erreicht werden, was insbesondere bei großen Potentialdifferenzen zwischen Spule und Hall-Element vorteilhaft ist. Durch die kreisringförmige Ausgestaltung der Spule und die damit verbundene Verringerung oder sogar Beseitigung einer Überlappung der Spule mit dem jeweils zugeordneten Hall-Element wird ein größerer Abstand und damit eine reduzierte elektrische Feldstärke zwischen den Spulen und dem jeweils zugeordneten Hall-Element realisiert.

Ist für jedes Hall-Element mindestens eine zusätzliche Kompensationsspule vorgesehen, kann auch bei einer derartigen Anordnung der Zeitaufwand für die Ladungstrennung innerhalb der Hall-Elemente minimiert und dadurch die erreichbare Datenrate deutlich erhöht werden.

Weitere Merkmale und Vorteile von Ausführungsformen der Erfindung ergeben sich aus der nachfolgenden Beschreibung mit Bezug auf die beigefügten Figuren.

### Kurze Beschreibung der Figuren

Es zeigen
- Fig. 1: ein schematisiertes Schnittbild einer ersten Ausführungsform des erfindungsgemäßen integrierten Schaltkreises,
- Fig. 2: eine schematisierte Draufsicht einer ersten Ausführungsform des erfindungsgemäßen integrierten Schaltkreises,
- Fig. 3: ein schematisiertes Schnittbild einer zweiten Ausführungsform des erfindungsgemäßen integrierten Schaltkreises,
- Fig. 4: ein schematisiertes Schnittbild einer dritten Ausführungsform des erfindungsgemäßen integrierten Schaltkreises,
- Fig. 5: eine schematisierte Draufsicht einer dritten Ausführungsform des erfindungsgemäßen integrierten Schaltkreises,
- Fig. 6: ein schematisiertes Schnittbild einer vierten Ausführungsform des erfindungsgemäßen integrierten Schaltkreises,
- Fig. 7: ein schematisiertes Schnittbild einer fünften Ausführungsform des erfindungsgemäßen integrierten Schaltkreises,
- Fig. 8: eine schematisierte Draufsicht einer fünften Ausführungsform des erfindungsgemäßen integrierten Schaltkreises,
- Fig. 9: ein schematisiertes Schnittbild eines integrierten Schaltkreises zur differentiellen Auswertung der Sensorsignale,
- Fig. 10: ein schematisiertes Schnittbild eines integrierten Schaltkreises zur differentiellen Auswertung der Sensorsignale mit Kompensationsspulen und
- Fig. 11: ein schematisiertes Schnittbild eines integrierten Schaltkreises zur differentiellen Auswertung der Sensorsignale mit erhöhter Durchbruchfestigkeit.

### Beschreibung der Beispiele

In einem Substrat 1, beispielsweise einem dotierten Siliziumsubstrat, ist ein Hall-Element 2 integriert. Auf der Oberfläche des Substrats 1 ist eine erste Isolationsschicht 3, beispielsweise Siliziumoxid, angeordnet. Auf der Isolationsschicht 3 befindet sich eine Metallisierungsschicht, welche eine erste planare Spule 4 umfasst. In vertikaler Richtung über der ersten planaren Spule 4 befindet sich eine zweite Isolationsschicht 5, auf der eine zweite planare Spule 6 angeordnet ist. Die erste Spule 4 und die zweite Spule 6 sind über eine Durchkontaktierung 7, häufig auch als Via bezeichnet - derart miteinander in Reihe geschaltet, dass sich bei Beaufschlagung mit einem Datenstrom I_{Strom} in den Spulen ein Stromfluss in gleicher Richtung ergibt. Der Datenstrom repräsentiert dabei die zu übertragende Information.

Die erste Spule 4 und die zweite Spule 6 sind zumindest im Wesentlichen konzentrisch zum Hall-Element 2 angeordnet, so dass ein durch einen Stromfluss in den Spulen erzeugtes Magnetfeld das Hall-Element 2 durchsetzt. Das Hall-Element 2 kann dabei in das Substrat 1 integriert sein oder auch auf dem Substrat 1 angeordnet sein. Eine Änderung des Stromflusses durch die Spulen bewirkt eine Änderung des resultierenden magnetischen Feldes am Hall-Element 2. Die zugehörige Hall-Spannung, welche als Ausgangssignal des Hall-Elementes dient, ändert sich proportional zum einwirkenden Magnetfeld und damit auch proportional zum angelegten Datenstrom. Durch Auswerten der Signalflanken des Ausgangssignals des Hall-Elements, also der Hall-Spannung, kann die Dateninformation zurück gewonnen werden. Durch die elektrische Isolierung des Hall-Elements 2 von den Spulen 4 und 6 wird auf diese Weise eine galvanisch getrennte Informationsübertragung realisiert.

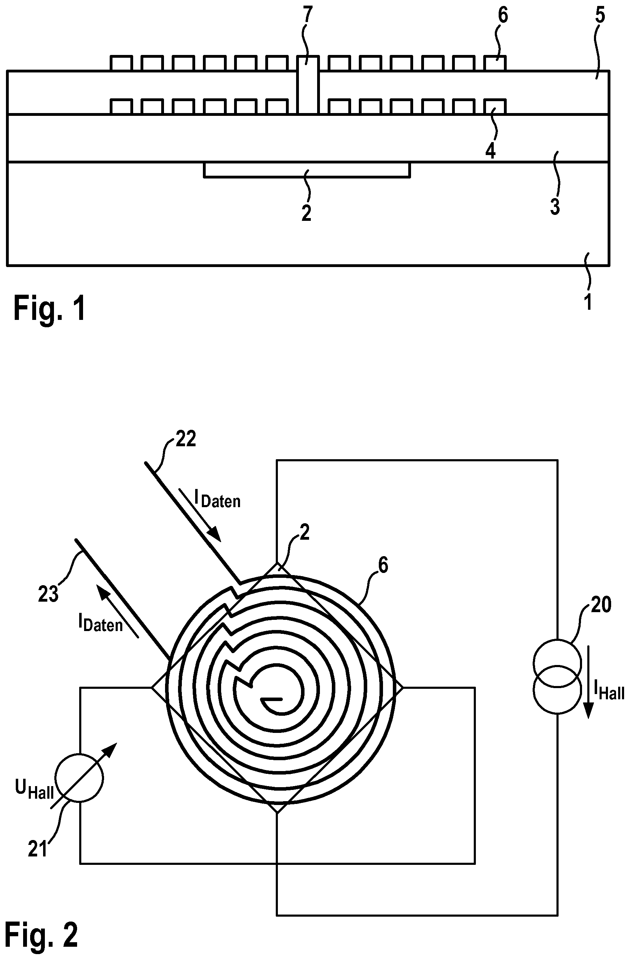

Es sei darauf hingewiesen, dass die Größenverhältnisse in den Fig. 1-10 nicht maßstabsgetreu wiedergegeben sind.

Die in Fig. 2 dargestellte schematisierte Draufsicht entspricht im Wesentlichen der in Fig. 1 dargestellten ersten Ausführungsform der Erfindung. Zusätzlich ist eine Stromquelle 20 dargestellt, welche das Hall-Element 2 mit einem Strom I_{Hall} speist sowie ein Spannungsmessgerät 21 zur Messung des Ausgangssignals in Form des Spannungsabfalls an dem Hall-Element 2. In der Draufsicht ist lediglich die zweite Spule 6 erkennbar, welche aus Gründen der Übersichtlichkeit der Darstellung im Gegensatz zur Darstellung gemäß Fig. 1 einen etwas kleineren Durchmesser aufweist, so dass die Ecken des quadratisch dargestellten Hall-Elements 2, an welchem die Anschlüsse der Stromversorgung 20 und des Spannungsmessgerätes 21 angeschlossen sind, nicht von der Spule 6 überdeckt werden. Die erste Spule 4 liegt bei der dargestellten Ausführungsform weitgehend deckungsgleich unterhalb der zweiten Spule 6 und ist daher nicht dargestellt. Die Abmessungen und Ausgestaltungen der Spulen 4 und 6 sind jedoch frei wählbar und können somit individuell an die jeweiligen Anforderungen angepasst werden. So kann beispielsweise alternativ zu der dargestellten spiralförmigen Ausgestaltung der Spulen auch eine andere geometrische Form gewählt werden, wie zum Beispiel die Anordnung von Leiterbahnen der Spule entlang der Kante eines Rechtecks. Ebenso können Durchmesser und Abstände der einzelnen Windungen sowie die Windungszahlen beliebig variiert werden. Auch können die erste Spule 4 und die zweite Spule 6 zueinander unterschiedlich ausgestaltet sein.

Schematisch ist in Fig. 2 auch die Zuführung des Datenstroms I_{Daten} zur zweiten Spule 6 in Form einer Leitungsstruktur 22 dargestellt. Die ebenfalls dargestellte Leitungsstruktur 23 zur Zurückführung des Datenstroms ist nicht mit der dargestellten zweiten Spule 6, sondern mit der darunter liegenden und deshalb nicht sichtbaren ersten Spule 4 verbunden. Die beiden Spulen 4 und 6 sind über die in der Draufsicht nicht erkennbare Durchkontaktierung 7 elektrisch miteinander verbunden. Alternativ zu der dargestellten Ausführungsform kann selbstverständlich der Datenstrom I_{Daten} auch zunächst der untenliegenden ersten Spule 4 und anschließend über die Durchkontaktierung 7 zur zweiten Spule 6 geleitet werden. Entscheidend ist lediglich, dass die beiden Spulen 4 und 6 derart in Reihe geschaltet sind, dass sich in den Spulen ein Stromfluss in gleicher Richtung ergibt.

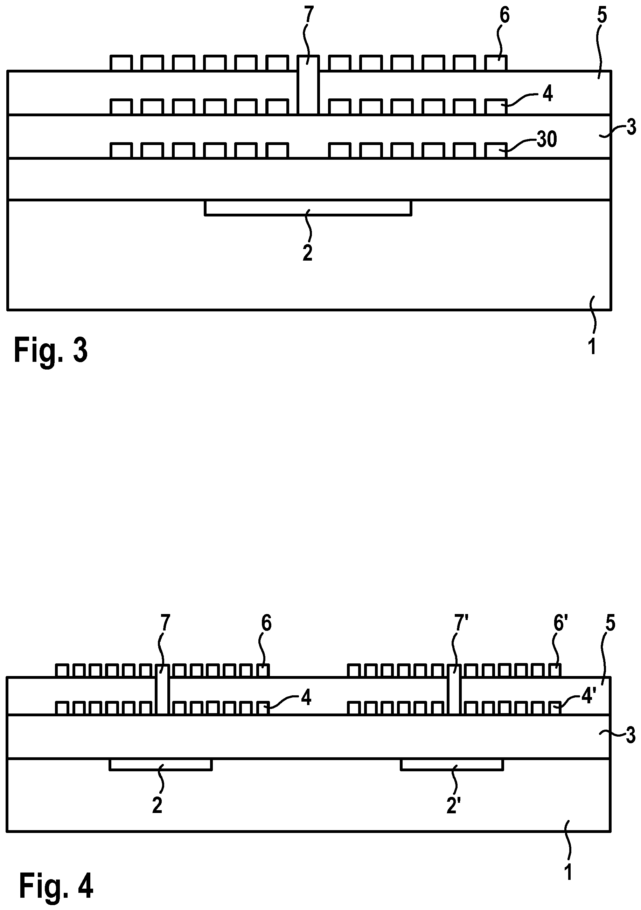

Gemäß der in Fig. 3 dargestellten zweiten Ausführungsform des erfindungsgemäßen integrierten Schaltkreises ist zusätzlich zu den datentragenden Spulen 4 und 6 eine Kompensationsspule 30 vorgesehen, welche im Wesentlichen konzentrisch zu dem Hall-Element 2 und in vertikaler Richtung zu dem Hall-Element 2 und den Spulen 4 und 6 beabstandet angeordnet ist sowie elektrisch getrennt von den Spulen 4 und 6 angesteuert werden kann. Dabei dient die von dem Hall-Element 2 gemessene Hall-Spannung als Eingangsgröße eines nicht dargestellten Reglers, welcher einen Kompensationsstrom I_{Komp} durch die Kompensationsspule 30 derart einstellt, dass das durch den Stromfluss in den datentragenden Spulen 4 und 6 erzeugte Magnetfeld durch das von dem Stromfluss in der Kompensationsspule 30 erzeugtes Magnetfeld kompensiert wird. Der Kompensationsstrom Iₖₒₘₚ dient dann als Messgröße, aus welcher die zu übertragende Dateninformation durch Auswerten der Signalflanken zurück gewonnen werden kann. Die konkrete Ausgestaltung der Kompensationsspule kann dabei beliebig variiert werden und ist insbesondere unabhängig von der Ausgestaltung der datentragenden Spulen 4 und 6. Durch das Betreiben des Hall-Elementes in einem Bereich um den Nulldurchgang, das heißt im Gleichgewicht, können Zeitverzögerungen für notwendige Ladungstrennungen in dem Hall-Element, welches einen Volumen-Halbleiter darstellt, deutlich reduziert und damit die erreichbare Datenrate bei der Informationsübertragung erheblich gesteigert werden. Die ReglerSchaltung kann dabei vorteilhaft mit dem Hall-Element 2 und den Spulen 4 und 6 sowie der Kompensationsspule 30 auf einem gemeinsamen Chip integriert werden.

Gemäß einer dritten Ausführungsform des erfindungsgemäßen integrierten Schaltkreises ist in dem Substrat 1 ein zweites Hall-Element 2' integriert, oder auf dem Substrat angeordnet (Fig. 4). Im Wesentlichen konzentrisch zu diesem zweiten Hall-Element 2' sind auf der ersten Isolationsschicht 3 eine dritte Spule 4' und auf der zweiten Isolationsschicht 5 eine vierte Spule 6' angeordnet. Die dritte Spule 4' und die vierte Spule 6' sind dabei über eine Durchkontaktierung 7' derart in Reihe geschaltet, dass sich durch die beiden Spulen ein Stromfluss in gleicher Richtung ergibt. Die Spulen 4, 4', 6 und 6' sind außerdem derart in Reihe geschaltet, dass sich in den Spulen 4 und 4' bzw. 6 und 6' jeweils ein Stromfluss in entgegen gesetzter Richtung ergibt.

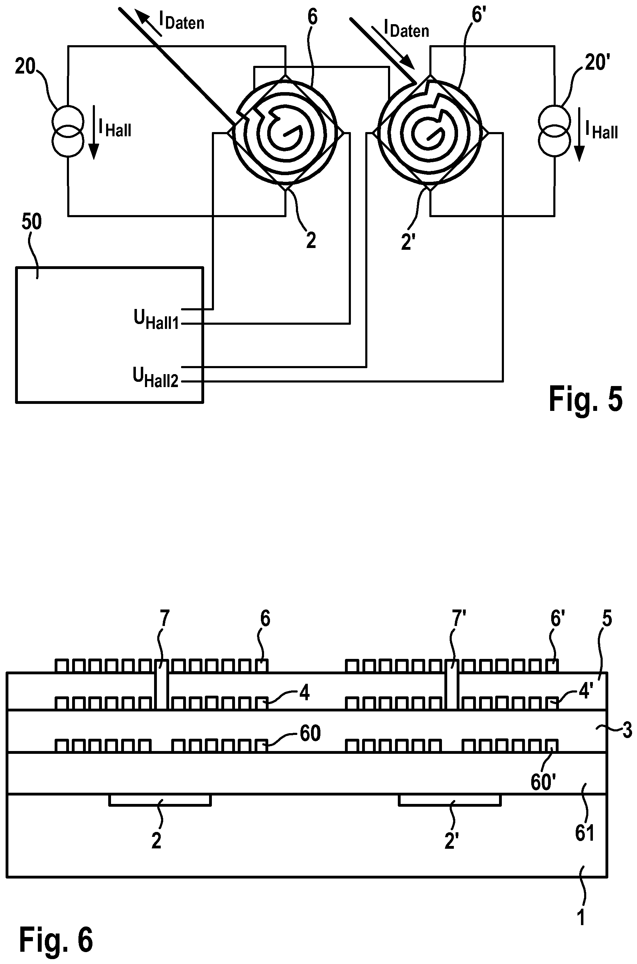

Eine schematisierte Draufsicht auf einen integrierten Schaltkreis gemäß der dritten Ausführungsform ist in Fig. 5 dargestellt. Dabei sind Stromversorgungen 20 und 20' für die Hall-Elemente 2 bzw. 2' vorgesehen. Gemäß der dargestellten Ausführungsform wird der vierten Spule 6' der Datenstrom I_{Daten} zugeführt und von der zweiten Spule 6 wieder abgeführt. Die Spulen 4 und 4' liegen jeweils annähernd deckungsgleich unterhalb der Spulen 6 bzw. 6' und sind daher nicht dargestellt. Auch bei dieser Ausführungsform kann die konkrete Ausgestaltung der Spulen beliebig variiert werden. Auch die Beschaltung kann beispielsweise dahingehend verändert werden, dass der Datenstrom einer beliebigen anderen Spule zugeführt und ggf. auch von einer beliebigen anderen Spule wieder abgeführt wird. Entscheidend für die erfindungsgemäße Funktion ist lediglich, dass die beiden übereinander angeordneten Spulen 4 und 6 bzw. 4' und 6' jeweils einen Strom in gleicher Richtung führen, wohingegen die nebeneinander angeordneten Spulen 4 und 4' bzw. 6 und 6' jeweils einen Strom in entgegen gesetzter Richtung führen.

Durch die entgegen gesetzte Stromrichtung in den Spulen 4 und 4' bzw. 6 und 6' und die daraus resultierenden entgegengesetzt gerichteten Magnetfelder ist es möglich, in einer Auswerteschaltung 50 die Differenz aus den Ausgangssignalen, also den Hall-Spannungen U_{Hall1} des ersten Hall-Elements 2 und U_{Hall2} des zweiten Hall-Elements 2' zu bilden und diese der weiteren Auswertung und somit der Rückgewinnung des Datensignals zugrunde zu legen. Durch diese differentielle Auswertung wird eine erhöhte Störfestigkeit gegenüber homogenen externen Magnetfeldern erreicht, da diese auf beide Hall-Elemente 2 und 2' einwirken und somit bei der Differenzbildung zumindest weitgehend eliminiert werden.

In Fig. 6 ist eine Weiterbildung der in den Fig. 4 und 5 dargestellten Ausführungsform dargestellt, bei der zusätzliche Kompensationsspulen 60 und 60' vorgesehen sind, welche auf einer zusätzlichen Isolationsschicht 61, welche sich zwischen dem Substrat 1 und der Isolationsschicht 3 befindet, angeordnet sind. Die Kompensationsspulen 60 und 60' sind dabei elektrisch getrennt von den Spulen 4, 4', 6 und 6' ansteuerbar. Dabei dienen die von den Hall-Elementen 2 und 2' gemessenen Hall-Spannungen als Eingangsgrößen eines nicht dargestellten Reglers, welcher Kompensationsströme durch die Kompensationsspulen 60 bzw. 60' derart einstellt, dass das durch den Stromfluss in den datentragenden Spulen 4 und 6 sowie 4' und 6' erzeugte Magnetfeld durch das von dem Stromfluss in der Kompensationsspulen 60 bzw. 60' erzeugte Magnetfeld jeweils kompensiert wird. Die Kompensationsströme I_{Komp1} und I_{Komp2} dienen dann als Messgrößen, aus welcher die zu übertragende Dateninformation durch differentielles Auswerten zurück gewonnen werden kann. Durch das Betreiben der Hall-Elemente in einem Bereich um den Nulldurchgang, das heißt im Gleichgewicht, können Zeitverzögerungen für notwendige Ladungstrennungen in den Hall-Elementen deutlich reduziert und damit die erreichbare Datenrate bei der Informationsübertragung erheblich gesteigert werden.

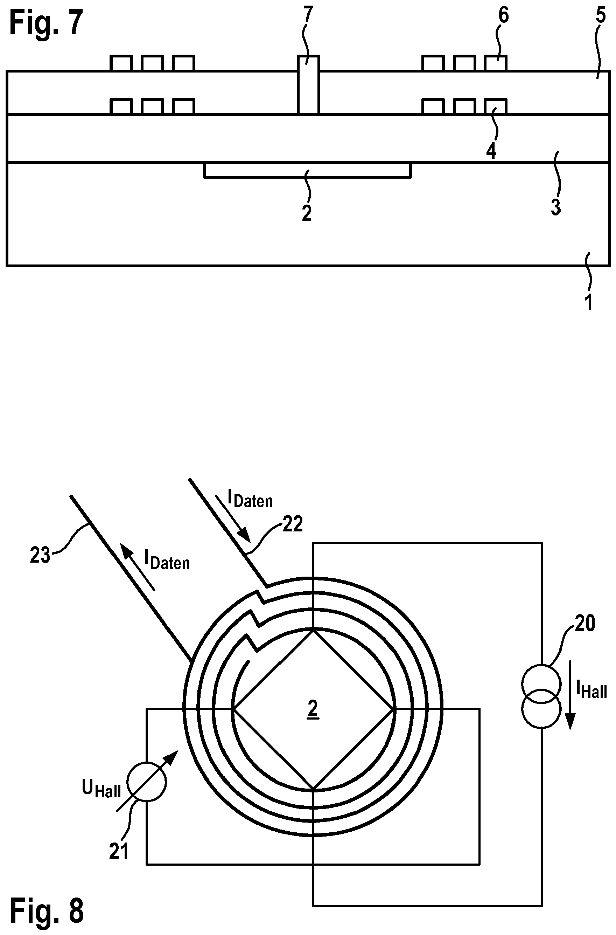

Gemäß einer weiteren Ausführungsform der Erfindung werden die erste Spule 4 und die zweite Spule 6 kreisringförmig ausgebildet. In der in Fig. 7 dargestellten Ausführung sind die beiden Spulen 4 und 6 derart ausgebildet, dass sich keine Überlappungsbereiche der Spulen 4 oder 6 mit dem Hall-Element 2 ergeben. Auf diese Weise wird ein größerer Abstand zwischen den Windungen der Spulen 4 und 6 und dem Hall-Element 2 und damit eine reduzierte elektrische Feldstärke zwischen den einzelnen Komponenten realisiert. Auf diese Weise wird die Durchbruchfestigkeit zwischen den Spulen 4 und 6 und dem Hall-Element 2 erheblich gesteigert. Denkbar ist auch eine Ausführungsform, bei der nur eine der Spulen, vorzugsweise die dem Hall-Element 2 näher gelegene erste Spule 4 kreisringförmig ausgestaltet ist. Auch eine kreisringförmige Ausgestaltung mindestens einer Spule, bei der sich eine teilweise Überlappung der Spule mit dem Hall-Element 2 ergibt, ist möglich.

Eine schematisierte Draufsicht einer Ausführungsform gemäß Fig. 7 ist in Fig. 8 dargestellt. Aus Gründen der Vereinfachung wurde dabei auf eine Darstellung der Durchkontaktierung 7, welche der elektrischen Verbindung der Spulen 4 und 6 dient, verzichtet. Mit Ausnahme der Ausgestaltung der beiden Spulen 4 und 6 unterscheidet sich die Ausführungsform gemäß der Figuren 6 und 7 nicht von der Ausführungsform gemäß der Figuren 1 und 2. Die dazu gemachten Ausführungen sind daher auch für die Ausführungsform gemäß den Figuren 6 und 7 gültig.

Bei allen beschriebenen Ausführungsformen können, auch falls nicht explizit genannt oder dargestellt, eine oder mehrere Kompensationsspulen eingesetzt werden, wodurch höhere Datenraten ermöglicht werden.

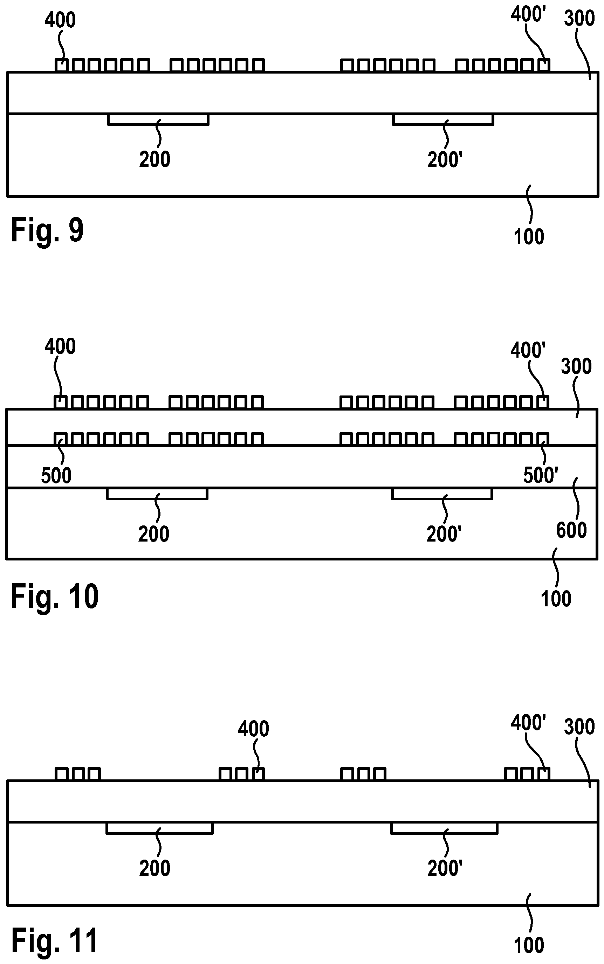

Die Fig. 9-11 zeigen weitere Beispiele integrierter Schaltkreise zur Informationsübertragung.

Das in Fig. 9 dargestellte Beispiel weist zwei in einem Substrat 1 integrierte oder auf dem Substrat 100 angeordnete Hall-Elemente 200 und 200' auf. Auf der Oberfläche des Substrats 100 ist eine Isolationsschicht 300, beispielsweise Siliziumoxid, angeordnet. Auf der Isolationsschicht 300 befindet sich eine Metallisierungsschicht, welche zwei planare Spulen 400 und 400' umfassen. Die planaren Spulen 400 und 400' sind dabei jeweils im Wesentlichen konzentrisch zu den Hall-Elementen 200 bzw. 200' angeordnet. Diese Anordnung ermöglicht eine differentielle Auswertung der Ausgangsspannungen der Hall-Elemente 200 und 200', wie sie schematisiert in Fig. 5 dargestellt ist. Dazu ist es erforderlich, dass die Spulen 400 und 400' derart in Reihe geschaltet sind, dass sich in den beiden Spulen ein Stromfluss in entgegen gesetzter Richtung ergibt, der wiederum zu entgegengesetzt gerichteten Magnetfeldern führt, welche das zugeordnete Hall-Element jeweils durchsetzen.

In Fig. 10 ist eine Weiterbildung des in Fig. 8 dargestellten integrierten Schaltkreises dargestellt, bei der zusätzliche Kompensationsspulen 500 und 500' vorgesehen sind, welche auf einer zusätzlichen Isolationsschicht 600, welche sich zwischen dem Substrat 100 und der Isolationsschicht 300 befindet, angeordnet sind. Die Kompensationsspulen 500 und 500' sind dabei elektrisch getrennt von den Spulen 400 und 400' ansteuerbar. Dabei dienen die von den Hall-Elementen 200 und 200' gemessenen Hall-Spannungen als Eingangsgrößen eines nicht dargestellten Reglers, welcher Kompensationsströme durch die Kompensationsspulen 500 bzw. 500' derart einstellt, dass das durch den Stromfluss in den datentragenden Spulen 400 und 400' erzeugte Magnetfeld durch das von dem Stromfluss in der Kompensationsspulen 500 bzw. 500' erzeugte Magnetfeld jeweils kompensiert wird. Die Kompensationsströme I_{Komp1} und I_{Komp2} dienen dann als Messgrößen, aus welcher die zu übertragende Dateninformation durch differentielles Auswerten zurück gewonnen werden kann. Durch das Betreiben der Hall-Elemente in einem Bereich um den Nulldurchgang, das heißt im Gleichgewicht, können Zeitverzögerungen für notwendige Ladungstrennungen in den Hall-Elementen deutlich reduziert und damit die erreichbare Datenrate bei der Informationsübertragung erheblich gesteigert werden.

Fig. 11 zeigt eine weitere Weiterbildung des in Fig. 8 dargestellten integrierten Schaltkreises. Dabei sind die Spulen 400 und 400' kreisringförmig ausgebildet, so dass sich die Spulen 400 und 400' nicht mit den Hall-Elementen 200 bzw. 200' überlappen. Auf diese Weise wird ein größerer Abstand zwischen den Windungen der Spulen 400 und 400' und den Hall-Elementen 200 bzw. 200' und damit eine jeweils reduzierte elektrische Feldstärke zwischen den Spulen und dem jeweils zugeordneten Hall-Element realisiert. Auf diese Weise wird die Durchbruchfestigkeit zwischen den Spulen 400 und 400' und den Hall-Elementen 200 bzw. 200' erheblich gesteigert, was insbesondere bei großen Potentialdifferenzen zwischen den Spulen und den Hall-Elementen vorteilhaft ist. Denkbar ist auch eine kreisringförmige Ausgestaltung der Spulen 400 und 400', bei der sich eine teilweise Überlappung der Spulen mit dem jeweils zugeordneten Hall-Element 200 bzw. 200' ergibt.

## Patentansprüche

1. Integrierter Schaltkreis zur Informationsübertragung mit
- einem Substrat (1),
- mindestens einem in dem Substrat (1) integrierten oder auf dem Substrat (1) angeordneten Hall-Element (2),
- einer im Wesentlichen konzentrisch zu dem Hall-Element (2) und in vertikaler Richtung zu dem Hall-Element (2) beabstandet angeordneten sowie von diesem galvanisch getrennten ersten Spule (4) und
- mindestens eine im Wesentlichen konzentrisch zu dem Hall-Element (2) und von diesem galvanisch getrennten sowie in vertikaler Richtung zu dem Hall-Element (2) und der ersten Spule (4) beabstandet angeordnete zweite Spule (6),
wobei die erste Spule (4) und die zweite Spule (6) elektrisch derart in Reihe geschaltet sind, dass sich in den Spulen (4, 6) ein Stromfluss in gleicher Richtung ergibt, wobei der integrierte Schaltkreis
- mindestens ein zweites in dem Substrat (1) integriertes oder auf dem Substrat (1) angeordnetes Hall-Element (2') aufweist,
- eine im Wesentlichen konzentrisch zu dem zweiten Hall-Element (2') und in vertikaler Richtung zu dem zweiten Hall-Element (2') beabstandet angeordnete und von diesem galvanisch getrennte dritte Spule (4') aufweist und
- eine im Wesentlichen konzentrisch zu dem zweiten Hall-Element (2') und in vertikaler Richtung zu dem zweiten Hall-Element (2') und der dritten Spule (4') beabstandet angeordnete vierte-Spule (6') aufweist,
wobei die Spulen (4, 4', 6, 6') elektrisch derart in Reihe geschaltet sind, dass sich in der dritten Spule (4') und vierten Spule (6') ein Stromfluss in gleicher Richtung ergibt, welcher entgegengesetzt zu dem Stromfluss in der ersten Spule (4) und in der zweiten Spule (6) ist,
**dadurch gekennzeichnet, dass**
der integrierte Schaltkreis mindestens eine im Wesentlichen konzentrisch zu dem Hall-Element (2) und in vertikaler Richtung zu dem Hall-Element (2) und den Spulen (4, 6) beabstandet angeordnete Kompensationsspule (30) aufweist, wobei die Kompensationsspule getrennt von der ersten Spule (4) und der zweiten Spule (6) ansteuerbar ist.

2. Integrierter Schaltkreis nach Anspruch 1 mit
- einer ersten Isolationsschicht (3), welche zwischen dem Hall-Element (2) und der ersten Spule (4) angeordnet ist und
- eine zweite Isolationsschicht (5), welche zwischen der ersten Spule (4) und der zweiten Spule (6) angeordnet ist.

3. Integrierter Schaltkreis nach Anspruch 1 mit mindestens zwei Kompensationsspulen (60, 60'), welche im Wesentlichen konzentrisch zu dem zugeordneten Hall-Element (2; 2') und in vertikaler Richtung zu den Hall-Elementen (2, 2') und den Spulen (4, 4', 6, 6') beabstandet angeordnet sind, wobei die Kompensationsspulen (60, 60') getrennt von den Spulen (4, 4', 6, 6') ansteuerbar ist.

4. Integrierter Schaltkreis nach einem der vorhergehenden Ansprüche, wobei die Spulen (4, 4', 6, 6') und/oder Kompensationsspulen (30, 60, 60') planare Spulen sind.

5. Integrierter Schaltkreis nach einem der vorhergehenden Ansprüche, wobei mindestens eine der Spulen (4; 4'; 6; 6') kreisringförmig ausgestaltet ist.

6. Integrierter Schaltkreis nach Anspruch 3, wobei die mindestens eine Spule (4; 4'; 6; 6') derart ausgestaltet ist, dass sich kein Überlappungsbereich mit einem Hall-Element (2; 2') ergibt.

## Claims

1. Integrated circuit for information transmission having
- a substrate (1),
- at least one Hall element (2) integrated in the substrate (1) or arranged on the substrate (1),
- a first coil (4) arranged substantially concentrically with respect to the Hall element (2) and spaced apart in the vertical direction with respect to the Hall element (2) and DC-isolated therefrom, and
- at least one second coil (6) arranged substantially concentrically with respect to the Hall element (2) and DC-isolated therefrom and spaced apart in the vertical direction with respect to the Hall element (2) and the first coil (4),
wherein the first coil (4) and the second coil (6) are electrically connected in series in such a way that a flow of current in the same direction is produced in the coils (4, 6),
wherein the integrated circuit
- has at least one second Hall element (2') integrated in the substrate (1) or arranged on the substrate (1),
- a third coil (4') arranged substantially concentrically with respect to the second Hall element (2') and spaced apart in the vertical direction with respect to the second Hall element (2') and DC-isolated therefrom, and
- a fourth coil (6') arranged substantially concentrically with respect to the second Hall element (2') and spaced apart in the vertical direction with respect to the second Hall element (2') and the third coil (4'),
wherein the coils (4, 4', 6, 6') are electrically connected in series in such a way that a flow of current in the same direction is produced in the third coil (4') and fourth coil (6'), which direction is opposite to the flow of current in the first coil (4) and in the second coil (6),
**characterized in that**
the integrated circuit has at least one compensating coil (30) arranged substantially concentrically with respect to the Hall element (2) and spaced apart in the vertical direction with respect to the Hall element (2) and the coils (4, 6), wherein the compensating coil can be actuated separately from the first coil (4) and the second coil (6).

2. Integrated circuit according to Claim 1 having
- a first insulation layer (3), which is arranged between the Hall element (2) and the first coil (4) and
- a second insulation layer (5), which is arranged between the first coil (4) and the second coil (6).

3. Integrated circuit according to Claim 1 having at least two compensating coils (60, 60'), which are arranged substantially concentrically with respect to the associated Hall element (2; 2') and spaced apart in the vertical direction with respect to the Hall elements (2, 2') and the coils (4, 4', 6, 6'), wherein the compensating coils (60, 60') can be actuated separately from the coils (4, 4', 6, 6').

4. Integrated circuit according to any one of the preceding claims, wherein the coils (4, 4', 6, 6') and/or compensating coils (30, 60, 60') are planar coils.

5. Integrated circuit according to any one of the preceding claims, wherein at least one of the coils (4; 4'; 6; 6') is configured in a circularly annular shape.

6. Integrated circuit according to Claim 3, wherein the at least one coil (4; 4'; 6; 6') is configured in such a way that no overlap region with a Hall element (2; 2') is produced.

## Revendications

1. Circuit intégré pour la transmission d'informations, comprenant
- un substrat (1),
- au moins un élément à effet Hall (2) intégré dans le substrat (1) ou disposé sur le substrat (1),
- une première bobine (4), disposée de manière sensiblement concentrique par rapport à l'élément à effet Hall (2) et espacée dans la direction verticale de l'élément à effet Hall (2) et aussi isolée galvaniquement de celui-ci et
- au moins une deuxième bobine (6), disposée de manière sensiblement concentrique par rapport à l'élément à effet Hall (2) et isolée galvaniquement de celui-ci et aussi espacée dans la direction verticale de l'élément à effet Hall (2) et de la première bobine (4),
la première bobine (4) et la deuxième bobine (6) étant branchées électriquement en série de telle sorte qu'un flux de courant dans la même direction se produit dans les bobines (4, 6),
le circuit intégré
- possédant au moins un deuxième élément à effet Hall (2') intégré dans le substrat (1) ou disposé sur le substrat (1),
- possédant une troisième bobine (4'), disposée de manière sensiblement concentrique par rapport au deuxième élément à effet Hall (2') et espacée dans la direction verticale du deuxième élément à effet Hall (2') et aussi isolée galvaniquement de celui-ci et
- possédant une quatrième bobine (6'), disposée de manière sensiblement concentrique par rapport au deuxième élément à effet Hall (2') et espacée dans la direction verticale du deuxième élément à effet Hall (2') et de la troisième bobine (4'),
les bobines (4, 4', 6, 6') étant branchées électriquement en série de telle sorte qu'un flux de courant dans la même direction se produit dans la troisième bobine (4') et dans la quatrième bobine (6'), lequel est opposé au flux de courant dans la première bobine (4) et dans la deuxième bobine (6),
**caractérisé en ce que**
le circuit intégré possède une bobine de compensation (30), disposée de manière sensiblement concentrique par rapport à l'élément à effet Hall (2) et espacée dans la direction verticale de l'élément à effet Hall (2) et des bobines (4, 6), la bobine de compensation pouvant être excitée séparément de la première bobine (4) et de la deuxième bobine (6).

2. Circuit intégré selon la revendication 1, comprenant
- une première couche d'isolation (3) qui est disposée entre l'élément à effet Hall (2) et la première bobine (4) et
- une deuxième couche d'isolation (5) qui est disposée entre la première bobine (4) et la deuxième bobine (6).

3. Circuit intégré selon la revendication 1, comprenant au moins deux bobines de compensation (60, 60'), laquelle est disposée de manière sensiblement concentrique par rapport à l'élément à effet Hall (2, 2') associé et espacée dans la direction verticale des éléments à effet Hall (2, 2') et des bobines (4, 4', 6, 6'), les bobines de compensation (60, 60') pouvant être excitées séparément des bobines (4, 4', 6, 6').

4. Circuit intégré selon l'une des revendications précédentes, les bobines (4, 4', 6, 6') et/ou les bobines de compensation (30, 60, 60') étant des bobines planes.

5. Circuit intégré selon l'une des revendications précédentes, au moins l'une des bobines (4, 4', 6, 6') ayant une configuration en forme d'anneau circulaire.

6. Circuit intégré selon la revendication 3, l'au moins une bobine (4, 4', 6, 6') étant configurée de telle sorte qu'il ne se produit aucune zone de superposition avec un élément à effet Hall (2, 2').
